# EUROPEAN PATENT APPLICATION

(11) **EP 0 580 895 A2**
(43) Date of publication of application: **02.02.1994**
(21) Application number: 92115170.0
(22) Date of filing: 04.09.1992
(51) Int. Cl.: H01L 21/66, H01L 23/544

(54) **Method of mapping a tested semiconductor device**

(30) Priority: 24.07.1992 JP 198286/92
(71) Applicant: FUJITSU LIMITED, Kawasaki-shi, Kanagawa 211 (JP)
(72) Inventor: Iijima, Nobuo, c/o Fujitsu Limited, Kawasaki-shi, Kanagawa, 211 (JP)
(74) Representative: Stebbing, Timothy Charles

(57) **Abstract**

A method of correcting data on the positions of chip regions (2) defined on a semiconductor wafer (1), which data is recorded on a map along with data on characteristics of semiconductor devices formed in the chip regions. This method is intended to enable the map to be referred to from positional information shown on the chips separated from the wafer. A chip region at which the center of the map is located is obtained on the basis of coordinate values provided for chip regions on the map in a characteristic test process, and the coordinates on the map are converted so that the coordinates of this chip region are (0, 0). With respect to each of the chip regions (e.g. 2A₁) belonging to the fourth quadrant of an orthogonal coordinate system (XY) having an origin at the center of the map, a verification is made as to whether a corresponding chip exists in the other quadrants. If no corresponding chip exists, coordinates for the corresponding chip (e.g. 2a₁) in the other quadrants are written on the map. It is thereby possible for deficient chips not selected as characteristic measurement objects to have coordinates written on the map.

## Description

This invention relates to a method of manufacturing a semiconductor device and, more particularly, to such a method using a map for storing test data on semiconductor devices such as integrated circuits formed in respective chip regions on a wafer.

Semiconductor devices formed on chip regions defined on a wafer are examined by a characteristic test using a prober (automatic testing machine) before the wafer is separated into chips. Chips which are recognized as non-defectives by the test are extracted from the wafer and assembled (packaged) in subsequent process steps.

Conventionally, regions of the wafer containing defective chips are marked with ink or the like and discarded in an assembly process. This method enables defective chips to be recognized by eye, but has the drawback that non-defective chips may become defective by being contaminated. Moreover, as the functionality of ICs improves, testing methods have come into use in which chips are not only separated into non-defectives and defectives but also sorted with respect to quality, to be put to appropriate uses. Such methods necessitate complicated test procedures and recording of a large amount of test results.

In view of these factors, systems are now being developed in which the amount of human intervention is minimized, the whole characteristic test and recordal of test results being performed under the control of a computer. A set of regions allocated in a memory area of a computer in correspondence with the placement of chip regions on a wafer, is called a map. In each of the map regions data is stored including position data, test results and other kinds of data, of a corresponding chip region on the wafer. Non-defective chips are extracted in the assembly process by referring to this map. The map is also utilized for examination of the history of semiconductor devices after the assembly process.

On the other hand, numerals or symbols indicating the position, i.e. co-ordinates for each chip on the wafer, are physically marked on each chip. This indication is based on co-ordinates determined in an exposure process, and these co-ordinates do not always coincide with the position data on the chip regions stored in the map. This is because co-ordinates given to each of the chip regions on the map are based on a co-ordinate system set by the operator in the characteristic test. For this reason, in a case where a certain abnormality occurs in assembled chips, it is not possible to utilize the physical markings on the chips to refer to the map for investigating initial characteristics of the chips.

In the characteristic test, no co-ordinates are given to so-called "deficient" chip regions regarded as extending out of the wafer (i.e. which appear to be incomplete), and testing of such chip regions is not conducted. This is because it is desirable to exclude deficient chips from the test, to improve the efficiency of the test process and to avoid wear on the probe used for the test.

The size of the wafer in the map, i.e the size of the wafer recognized by a characteristic testing machine, is determined by measuring the diameter of the wafer using the testing machine. However, if the measured diameter is smaller than the actual diameter owing to a measurement error, a chip region which is not actually extending out of the wafer is wrongly regarded as deficient, and no co-ordinates are given to it. The chip in such a region does not appear deficient, and therefore it may be regarded as normal at a later stage, and assembled. If a certain abnormality has occurred in such a chip, it is impossible to examine the history of the chip by referring to the map, since no co-ordinates are given. Alternatively, there is a risk of referring to the data for a different chip region on the map by mistake.

An embodiment of the present invention may provide a method of correcting position data written on the map so that the position data coincides with position information marked on the chips, i.e. the co-ordinates determined at the time of exposure.

An embodiment of the present invention may also enable the history of each semiconductor chip to be examined by referring to the map.

In addition, an embodiment of the invention may enable co-ordinates for chip regions, which do not actually extend out of the wafer but which are regarded as deficient by a characteristic test, to be stored in the map.

According to the present invention, there is provided a method of correcting data on the positions of chip regions defined on a semiconductor wafer, which data is recorded on a map along with data on characteristics of semiconductor devices formed in the chip regions, wherein a chip region at which the centre of the map is located is obtained on the basis of coordinate values provided for chip regions on the map in a characteristic test process, and the map co-ordinates are converted so that the co-ordinates of this chip region are (0, 0).

In a development of the invention, with respect to each of the chip regions belonging to the fourth quadrant of an orthogonal co-ordinate system having an origin at the centre of the map, a verification is made as to whether a corresponding chip exists in the other quadrants; if no corresponding chip exists, co-ordinates for corresponding chips in the other quadrants are written on the map.

In more detail, an embodiment of the present invention provides a method of manufacturing semiconductor devices including a process of testing semiconductor devices formed in a plurality of chip regions defined on a surface of a semiconductor wafer in such a manner that a maximum number of chip regions are arranged in each of the directions of rows and columns, before the chip regions are separated from the wafer, the method comprising the steps of:-
(1) Positioning the semiconductor wafer relative to a testing machine so that the contours (edges) of the wafer are tangential to perpendicular first and second axes defined on the testing machine, and thereafter rotating the wafer so that at least two orthogonal boundary lines defining the chip regions are respectively parallel to the first and second axes;
(2) Thereafter, obtaining data on the positions of the two boundary lines on the wafer surface relative to the first and second axes;
(3) Storing in a memory area a logical wafer having a diameter based on the size of the actual wafer and oriented tangential to the first and second axes, and allocating logical chip regions in the memory area on the basis of the size of the chip regions and said data on the positions of the two boundary lines relative to the first and second axes, wherein said two boundary lines and corresponding boundary lines of the logical chip regions are made to coincide;
(4) Obtaining co-ordinates for the logical chip regions based on an orthogonal co-ordinate system having two axes respectively parallel to the first and second axes and an origin which can be set to an arbitrary position, and writing the obtained co-ordinates in the memory area, wherein the logical chip regions which extend out of the logical wafer to such an extent that the proportion of the area outside the logical wafer to the area of one chip region is larger than a predetermined value, are omitted;
(5) Obtaining a central value of the co-ordinates of the logical chip regions belonging to at least one row closest to the first axis and a central value of the co-ordinates of the logical chip regions belonging to at least one column closest to the second axis; and
(6) Converting the co-ordinates of the logical chip regions written in the memory area into co-ordinates in a second orthogonal co-ordinate system which has an origin located at a point having the two central co-ordinate values, and which has axes respectively parallel to the first and second axes.

This method may further comprise the step of verifying, with respect to each of the logical chip regions in one of four quadrants of the second orthogonal co-ordinate system, said quadrant containing both a part of the logical chip regions belonging to the row closest to the first axis and a part of the logical chip regions belonging to the column closest to the second axis, whether the co-ordinates for the corresponding logical chip region in the other quadrants have been written in the memory area and, if not, writing them in the memory area.

That is, by using the present invention, co-ordinates on the map are converted into co-ordinates in a co-ordinate system having an origin located approximately at the centre of the wafer, irrespective of the setting of a co-ordinate origin during the characteristic measurement. Therefore, the co-ordinates can easily be related to the actual chips on the wafer and it is possible to refer to characteristic data on the map from the markings on the chips. In particular, if the markings on the chips are chip codes determined based on a co-ordinate system having an origin set at the centre of the wafer, the co-ordinates on the map coincide with the chip codes.

Also, in embodiments of the present invention, with respect to chip regions which do not actually extend out of the wafer but which have been treated as deficient in the test process, data on the positions of these chip regions is written on the map. It is therefore possible to confirm, by referring to the map, that the characteristic test has not been performed with respect to such chip regions.

Consequently, the cause of a defect in the assembled chips can be analysed more accurately and in detail, thus helping to improve the reliability of semiconductor devices. The map standardised with respect to chip region co-ordinates as described above is also effective in improving the reliability of an automatic assembly process performed by referring to the map data.

The inventors of the present invention observed that, in general, variations in the diameter of a wafer and errors in the measurement thereof do not exceed twice the size of the chip regions, and that the probability of the existence of deficient chips (i.e. chips extending out of the wafer) in the middle of the wafer (i.e. in a row and column selected to determine co-ordinates (a_{½}, b_{½}) on the map corresponding to the centre of the wafer), is very low.

Reference is made, by way of example, to the accompanying drawings, in which:-
Fig. 1 illustrates the positioning of a wafer in an exposure process;
Fig. 2 illustrates the positioning of the wafer and chip regions in a testing process;
Fig. 3 shows a co-ordinate correction method embodying the present invention;
Fig. 4 illustrates the assignment of co-ordinates to chip regions on the map;
Fig. 5 is a block diagram of a testing apparatus to which the present invention may be applied; and
Fig. 6 is a plan view of the procedure for providing chips regarded as deficient with co-ordinates.

To facilitate the understanding of the present invention, the outline of the procedure of positioning a wafer in an exposure process and determining coordinates for each of chip regions will be described below.

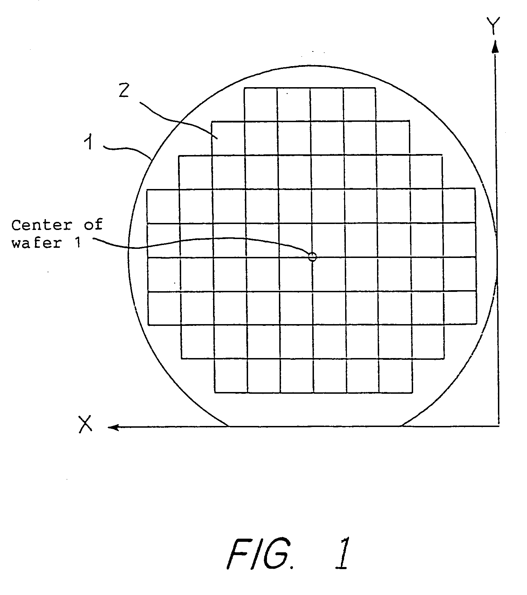

The actual position of chip regions on the wafer is determined when patterns of semiconductor devices or the like are formed on the respective chip regions by exposure. For example, as shown in Fig. 1, a wafer 1 is positioned on an exposure apparatus so that a straight cut side (OF: orientation flat) formed on the wafer 1 coincides with the X-axis of an orthogonal coordinate system determined relative to the exposure apparatus, while the circumference of the wafer 1 is tangential to the Y-axis.

The exposure apparatus is supplied with data on the sizes of the wafer 1 and chip regions 2 and determines the arrangement of chip regions 2 based on this data, so that the number of chip regions 2 which can be allocated on the wafer 1 is maximized. The arrangement of the chip regions 2 is symmetrical about an orthogonal axis passing through the center of the wafer 1 except for chip regions which have not been allocated because of a restriction due to the OF and, accordingly, symmetrical about the center of the wafer 1. In this manner, the position of each chip region 2 is designated by the coordinates (x, y) with respect to the X-Y coordinate axes. Based on these coordinate values, a predetermined pattern is successively projected onto the chip regions 2 by a step-and-repeat method. The coordinates (x, y), converted so that the origin of the X-Y coordinate axes is located approximately at the center of the wafer 1, are called "chip codes". The reason for the expression "approximately at the center of the wafer 1" is because the actual diameter of the wafer 1 may vary by about 1 % from the diameter given as the wafer 1 diameter data to the exposure apparatus, and because it is therefore possible that the origin of the coordinate system used as the basis for the layout of the chip regions 2 will deviate from the center of the wafer 1.

To improve the exposure efficiency, a plurality of (e.g., two to four) chip regions 2 may be exposed by one projection (shot). Ordinarily, the steps of etching, removing a resist mask, and other operations are performed after the exposure. The exposure step, the etching step and other steps are repeated according to the kind of the necessary pattern. During this process or in the final exposure step, numerals or symbols indicating values of the coordinates (x, y) on the wafer 1 are formed on each chip region 2. This indication remains after the assembly of the chips to serve as a mark for discriminating each chip.

An embodiment in which the present invention is applied to the process for a characteristic test of semiconductor devices actually formed in chip regions arranged on a wafer will be described below.

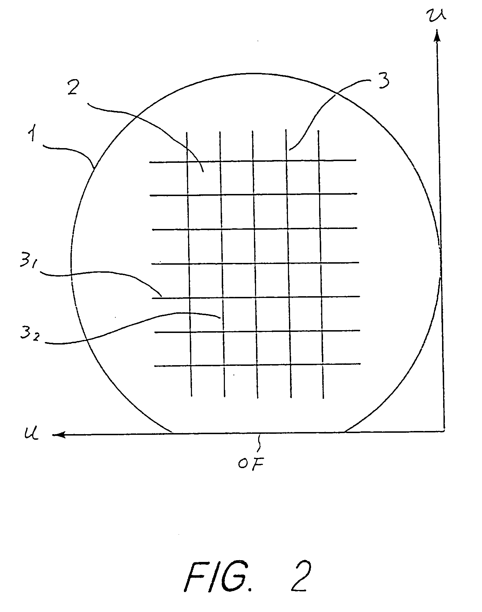

First, the wafer is positioned relative to a characteristic testing machine. This positioning is basically the same as the above-described method for positioning at the time of exposure. That is, as shown in Fig. 2, the wafer is positioned on the basis of an axis u and another axis v defined on the characteristic testing machine so as to be perpendicular to each other. The wafer 1 is positioned so that the axis u coincides with the orientation flat (OF) provided on the wafer 1 while the circumference of the wafer 1 is tangential to axis v. Then, lines representing boundaries between the chip regions 2 (ordinary scribe lines) 3₃ and 3₂ are detected. Data on the positions of boundary lines 3 relative to the characteristic testing machine is thereby obtained. If the boundary lines 3 are not parallel to the OF, the wafer is adjusted by being rotated so that the boundary lines 3₁ are parallel to the axis u.

On the other hand, the diameter of wafer is measured, for example, by an electrostatic capacity method or the like. Measurement data thereby obtained is input to the testing machine. The arrangement of chip regions 2 on wafer 1 is presumed on the basis of this diameter data, the chip region 2 size data previously given and the data on the positions of the boundary lines 3₁ and 3₂ relative to the characteristic testing machine. The contour of the wafer (logical wafer) and the arrangement of the chip regions (logical chip regions) allocated on the wafer, which are based on the above-mentioned categories of data, are displayed, for example, on a display unit attached to the testing machine. Some of the chip regions (deficient chips) which are considered to be not entirely located within the area of the logical wafer are displayed distinctively, for example, by being colored.

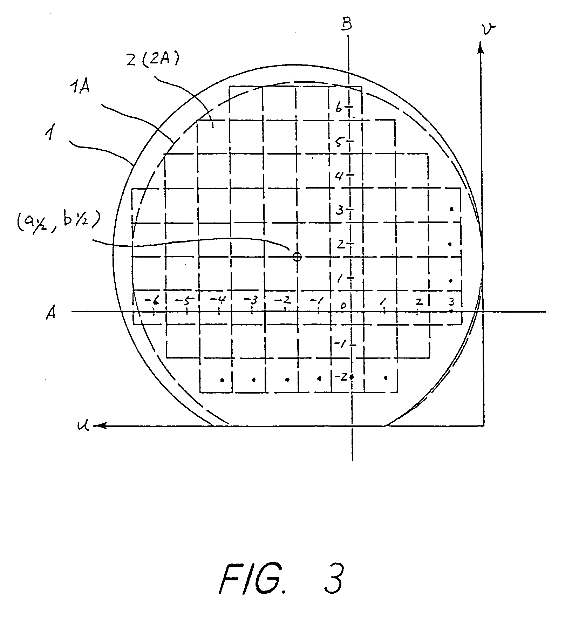

Fig. 3 shows the areas of the logical wafer and the chip regions shown on the display. The circle formed of the solid line represents the actual wafer 1, which is not shown on the display, but which is illustrated for comparison. The circle formed of the broken line represents the wafer on the map drawn based on the diameter data measured by the characteristic test, i.e., a logical wafer 1A. That is, Fig. 3 illustrates a case in which the logical wafer 1A is recognized to be smaller than the actual wafer 1 owing to a measurement error. Squares defined by the broken lines represent the chip regions 2 which are presumed to be allocated on the wafer 1. Logical chip regions 2A on the map are allocated on the basis of the boundary lines 3 of the actual chip regions 2 whose positions relative to the axes u and v have been obtained. The size of logical chip regions 2A is determined on the basis of the data on the size of the actual chip regions 2. Accordingly, it can be considered that, if the actual wafer 1 and the logical wafer 1A are superposed as shown in Fig. 3, the logical chip regions 2A can be superposed on the chip regions 2 on the actual wafer 1.

The operator of the characteristic test machine sets a suitable orthogonal coordinate system having two axes A and B parallel to the axes u and v, respectively, on the basis of the displayed arrangement of chip regions 2A. The operator selects, by dialogue with the display, logical chip regions 2A which do not extend out of the logical wafer 1A to such an extent that the proportion of the area of each region outside the logical wafer to the whole area of one chip region is larger than a predetermined value. The operator determines such logical chip regions 2A as characteristic measurement objects. Data on coordinates (a, b) on the orthogonal coordinate axes A and B of the measurement object chip regions 2A determined in this manner is written on the map. As units of coordinate values a and b, the dimensions of the chip regions 2A in the directions along the axis A and the axis B are set to "1".

Characteristics of the chips in the regions 2A having coordinate (a, b) data written on the map are successively measured and characteristic data thereby obtained is written on the map. If necessary, this characteristic data is compared with reference values, and data for discriminating non-defective and defective chips or data for classifying the chips according to quality levels is written on the map. As mentioned above, since chip regions having an area outside the wafer the proportion of which is greater than a predetermined value are regarded as deficient and not included in the measurement objects, the map has no coordinates and characteristic data for such chip regions.

In the arrangement schematically illustrated in Fig. 3, there are six chip regions 2A in the row closest to the axis u, while there are four chip regions 2A in the column closest to the axis v. Coordinate values a of the six chip regions 2A are -4, -3, .., 0, 1, and coordinate values b of these chip regions 2A are -1. Coordinate values a of the four chip regions 2A are 3, and coordinate values b of these chip regions 2A are 0, 1, 2, 3. Points determined by the combinations of these coordinate values a and b are shown as dots in the corresponding chip regions 2A. That is, the positions of the chip regions 2A on the map are represented by the coordinates (a, b) of dots belonging to the chip regions 2A. With respect to a case where a dot is located on the boundary line between two adjacent chip regions 2A or on the point of intersection of the boundary lines between four adjacent chip regions 2A, the chip region 2A to which the dot belongs is previously determined.

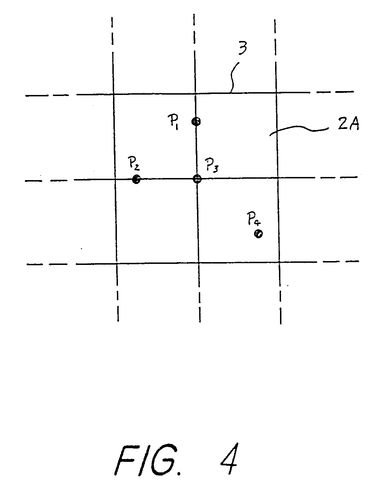

For example, points P₁ and P₂ shown in Fig. 4 are shown as dots located on the boundary lines between two adjacent pairs of chip regions 2A, and a point P₃ is shown as a dot located on the point of intersection of the boundary lines between four adjacent chip regions 2A. In the former case, one of the two chip regions having the greater coordinate value a or b on the coordinate axis A or B is previously determined as the chip region to which the dot belongs. In the latter case, one of the four chip regions having both the greater coordinate values a and b on the coordinate axes A and B is previously determined as the chip region to which the dot belongs. The dot indicated at P₄ in Fig. 4 is located inside the chip regions 2A. Needless to say, this arrangement is determined in conformity with the method of determining the coordinate (x, y) in the exposure process.

Referring back to Fig. 3, the central coordinate a of the chip regions 2A belonging to the row closest to the axis u (i.e., the row having the smallest coordinate value b) and the central coordinate b of the chip regions 2A belonging to the column closest to the axis v (i.e., the column having the smallest coordinate value a) are obtained. For example, to obtain the central coordinates, the average a_{1/2} of the maximum and the minimum of the coordinate values a of the boundaries between the chip regions 2A belonging to the row and the average b_{1/2} of the maximum and the minimum of the coordinate values b of the boundaries between the chip regions 2A belonging to the column are calculated. The point having coordinates (a_{1/2}, b_{1/2}) obtained in this manner corresponds to the origin of the coordinate system serving as the basis for the above-described layout of the chip regions 2 in the exposure process and, therefore, coincides approximately with the center of the actual wafer 1. That is, the actual chip region 2 corresponding to the chip region 2A related to the point having the coordinates (a_{1/2}, b_{1/2}) is located closest to the center of the actual wafer 1. Such chip region 2A is referred to as the central chip region hereinafter.

The coordinates (a, b) of all the chip regions 2A on the map are then converted so that the coordinates of the central chip region 2A become (0, 0). That is, if the coordinates already written on the map with respect to the central chip regions 2A are (a₀, b₀), the coordinates (a, b) of the chip regions 2A on the map are rewritten to (a-a₀, b-b₀). The coordinates of the chip regions 2A on the map rewritten in this manner coincide with chip codes given to the actual chip regions 2 in the exposure process. It is therefore possible to refer to the map from the chip codes.

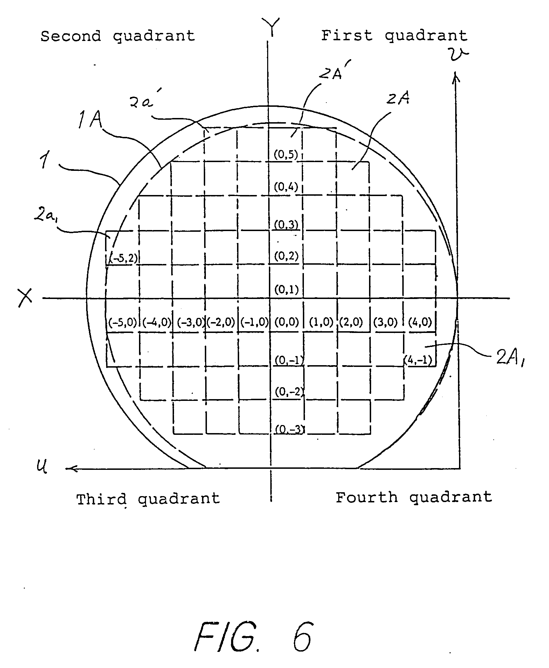

The above method is rather strict in obtaining the central coordinates (a_{1/2}, b_{1/2}), since the rewritten coordinates on the map are to be used for the correction of apparent deficient chips, as described in later by referring to Fig. 6. If it is aimed to perform only the coordinate conversion of the map, the central coordinates (a_{1/2}, b_{1/2}) can be determined by calculating the average of the coordinate values a and b with respect to the chip regions 2A belonging to the row closest to the axis u and to the column closest to the axis V.

Needless to say, the chip regions 2A on the map, whose coordinates are converted as described above can be related to chip regions 2 on the wafer to which coordinates other than those of the chip codes are given. If either or both of the number of chip regions 2A belonging to the row closest to the axis u and the number of chip regions 2A belonging to the column closest to the axis v are even numbers, the point having the coordinates (a_{1/2}, b_{1/2}) is located on the boundary line between two adjacent chip regions 2A or the point of intersection of the boundary lines between four adjacent chip regions 2A. In this case, one of the adjacent chip regions to which this point belongs is determined in the same manner as the method of determination of the chip regions 2A coordinates described above with reference to Fig. 4.

The reason for selecting the row closest to the axis u and the column closest to the axis v before the determination of the coordinates (a_{1/2}, b_{1/2}) is because, since the positioning of the wafer 1 and the allocation of the chip regions 2 or 2A are performed on the basis of the axes u and v in the exposure process and the characteristic test, the possibility of occurrence of positional errors due to variations in the diameter of the wafer 1 or errors in the measurement of the diameter and, hence, the possibility of deficient chip discrimination errors due to such variations and measurement errors is smaller with respect to a row or a column closer to the axis u or v. For this reason, it is possible to obtain more reliable results by the method of selecting a plurality of (at least three) rows including the row closest to the axis u and a plurality of columns including the column closest to the axis v. This method is conducted by calculating the averages of the maximum and the minimum of the coordinate values a and b of the boundaries between the chip regions with respect to each of the selected rows and columns, determining the representative average values of each of the groups of coordinate values a and b in a majority decision manner, and determining the cental coordinates (a_{1/2}, b_{1/2}).

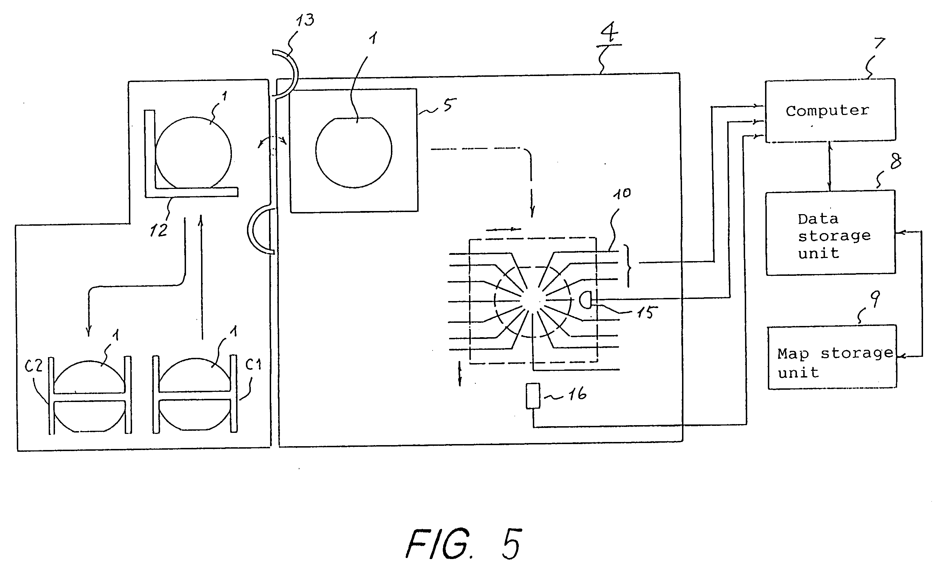

Fig. 5 is a block diagram schematically showing the construction of the characteristic testing apparatus to which the present invention is applicable. A wafer 1 accommodated in a cassette C1 is transported to a pre-aligner 12 to be roughly positioned and is thereafter placed on an XY stage 5 in a home position of a characteristic testing machine (prober) 4 by a handler 13 rotated as indicated by the arrows. The positioning of wafer 1, the detection of boundary lines 3 between chip regions 2 and the rotational adjustment are performed on the bases of the axes u and v, as described above with reference to Fig. 2. Then, the wafer 1 is transported to a predetermined position in the characteristic testing machine 4 by the XY stage 5, and the detection of the circumference and the measurement of the diameter are performed, for example, with an electrostatic capacity sensor 15. Simultaneously, the boundary lines 3 between the chip regions 2 on the wafer 1 are detected. The detection of the boundary lines 3 is performed, for example, with a CCD camera 16 provided on the characteristic testing machine 4. In this manner, data on the positions of the wafer 1 and the boundary lines 3 relative to the characteristic testing machine is obtained. All these operations are performed under the control of a computer (CPU) 7.

The computer 7 infers the contour of the wafer 1 and the arrangement of the chip regions 2 on the wafer 1 from the wafer 1 diameter data obtained as described above, chip region 2 size data previously stored in a data storage unit 8, and the boundary line 3 position data detected as described above, and stores data on the wafer contour and the chip region arrangement in a memory area of a map storage unit 9.

Thereafter, a coordinate system having orthogonal axes A and B is set and the area in which chips to be measured with respect to characteristics are arranged is determined by the operator, as described above with reference to Fig. 3. The coordinates (a, b) thereby determined with respect to the axes A and B are written in the memory area of the map storage unit 9.

The computer 7 makes a probe 10 contact terminals of each of semiconductor devices formed in the measurement object chip regions on the wafer 1 while moving the XY stage 5 based on a step-and-repeat method to measure device characteristics. In this manner, the characteristics of the chips in the chip regions 2 are successively measured. Characteristic data corresponding to the chip regions where the characteristics thereof have been measured is written in the memory area of the map storage unit 9. After the completion of the characteristic measurement, the wafer 1 is returned to the home position by the XY stage 5, transported to the pre-aligner 12 by the handler 13, and thereafter transported to be accommodated in another cassette C2.

When the measurement of the characteristics of the predetermined chip regions 2 is completed, the computer 7 calculates the coordinates (a_{1/2}, b_{1/2}) and performs the coordinate conversion into coordinates (a-a₀, b-b₀) and other operations by the above-described procedure, and writes the results of these operations in the memory area of the map storage unit 9.

In this manner, the coordinates of the logical chip regions 2A on the map are corrected so as to coincide with chip codes in which the chip regions 2 located approximately at the center of the wafer 1 has coordinates (0, 0).

Fig. 6 is a schematic diagram of another embodiment of the present invention, showing wafer 1 and logical chip regions 2A on the map which correspond to actual chip regions 2 on the wafer 1. When the map is formed, the positioning of the wafer 1 relative to the characteristic testing machine is performed on the basis of orthogonal axes u and v defined on the testing machine, as described above. That is, the wafer 1 is positioned so that the orientation flat (OF) coincides with the axis u while the circumference of the wafer 1 is tangential to the axis v. As described above, this positioning is the same as the positioning of the wafer 1 relative to the exposure apparatus.

On the other hand, the coordinates of chip regions 2A on the map are converted into those in an orthogonal coordinate system with X- and Y-axes having an origin approximately at the center of the wafer 1, as described above. Ordinarily, as illustrated, the chip region 2A located approximately at the center of the wafer 1 has coordinates (0, 0), and the coordinate values x and y are increased or reduced by 1 with shifts of the chip region 2A position from the coordinates (0, 0).

In the case of the above-described method of positioning the wafer 1 in the exposure process and the characteristic test process, with respect to a row closer to the axis u or a column closer to the axis v, the arrangement of chip regions 2 or 2A belonging to this row or column can be influenced less by a variation in the wafer 1 diameter or a measurement error. That is, in a quadrant surrounded by the X-axis, the Y-axis and the axes u and v (ordinarily called a fourth quadrant with respect to the XY coordinate system), the possibility that chips in chip regions 2 allocated on the actual wafer 1 or chip regions 2A allocated on the logical wafer 1A on the map will become deficient due to the variation or measurement error in the diameter of the wafer 1, is smaller in comparison with chip regions 2 or 2A in the other quadrants. Then, chip regions 2A in the fourth quadrant are developed in the other quadrants with the X- or Y-axis used as the axis of symmetry, and a verification is made on the map as to whether corresponding chip regions 2A exist in the other quadrants.

For example, as shown in Fig. 6, if the diameter of the wafer 1 is recognized to have a value smaller than the actual diameter owing to an error in the diameter measurement in the characteristic test, a chip region 2a₁ in the second quadrant, which is located within the actual wafer 1, is regarded as extending out of the logical wafer 1A. The chip region 2a₁ has no coordinates written on the map. The chip region 2A₁ existing in the fourth quadrant in correspondence with the chip regions 2a₁ is not deficient, and has coordinates (4, -1). In the case shown in Fig. 6, since the chip region 2A having coordinates (0, 0) exists in the fourth quadrant, coordinates (-5, 2) are given to the chip region 2a₁ regarded as deficient and are written on the map.

In the above-mentioned development, it is possible that chip regions 2A' corresponding to none of the chip regions 2A in the third and fourth quadrant exist in the first and second quadrants. This is because the corresponding chip regions are not allocated on the third and fourth quadrants under the influence of the OF. In such a case, the coordinates of the chip regions 2A' already written on the map are preserved.

However, the state of a chip region 2a' among the chip regions 2A', which is regarded as deficient and which has no coordinates written on the map is confirmed with the eye, and coordinates are thereafter given to it.

The map on which the coordinates of the chip regions 2a and 2a' both regarded as deficient are written has more detailed information corresponding to the chip regions 2 on the actual wafer 1. It is thereby possible to refer to the map with respect to the deficient chips 2a.

## Claims

1. A method of manufacturing semiconductor devices including a process of testing semiconductor devices formed in a plurality of chip regions defined on a surface of a semiconductor wafer in such a manner that a maximum number of chip regions are arranged in each of the directions of rows and columns, before the chip regions are separated from the wafer, said method comprising the steps of:
(1) positioning the semiconductor wafer relative to a testing machine for said testing so that the contours of the semiconductor wafer are equivalently tangent to a first axis and a second axis defined on the testing machine so as to be perpendicular to each other, and thereafter adjusting the semiconductor wafer so that at least orthogonal two of boundary lines defining the chip regions are respectively parallel to the first and second axes by rotating the semiconductor wafer;
(2) obtaining data on the positions of the two boundary lines on the semiconductor wafer surface relative to said first and second axes after the positioning and the rotation adjustment of the semiconductor wafer;
(3) drawing on a memory area a logical wafer having a diameter based on data on the size of the semiconductor wafer and equivalently tangent to said first and second axes, and allocating logical chip regions on the memory area on the basis of data on the size of the chip regions and the data on the positions of the two boundary lines relative to said first and second axes, wherein the two boundary lines and those of the logical chip regions are overlaid on each other;
(4) obtaining coordinates for the logical chip regions based on an orthogonal coordinate system having two axes respectively parallel to said first and second axes and an origin which can be set to an arbitrary position, and writing the obtained coordinates in the memory area, wherein the logical chip regions which extend out of the logical wafer to such an extent that the proportion of the area outside the logical wafer to the area of one chip region based on the size data is larger than a predetermined value, are omitted;
(5) obtaining a central value of the coordinates of the logical chip regions belonging to at least one row closest to said first axis and a central value of the coordinates of the logical chip regions belonging to at least one column closest to said second axis; and
(6) converting the coordinates of the logical chip regions written in the memory area into coordinates on another orthogonal coordinate system which has an origin located at a point having said two central values as coordinate values, and which has two axes respectively parallel to said first and second axes.

2. A method of manufacturing semiconductor devices according to claim 1, further comprising the steps of:
verifying, with respect to each of the logical chip regions in one of four quadrants of said another orthogonal coordinate system, the one quadrant containing both a part of the logical chip regions belonging to the row closest to said first axis and a part of the logical chip regions belonging to the column closest to said second axis, whether the coordinates for the corresponding logical chip region in the other quadrants have been written in the memory area; and
writing, in the memory area, coordinates for the corresponding logical chip region in the other quadrants on said another orthogonal coordinate system, if the coordinates for the corresponding logical chip region have not been written.

3. A method of manufacturing semiconductor devices according to claim 1 or 2, wherein at least three rows or three columns are selected as at least one row closest to said first axis or at least one column closest to said second axis, central values of the coordinates of the logical chip regions belonging to each row or column are obtained, and a representative value determined from these central values in a majority decision manner is used as the central value for determining the origin of said another orthogonal coordinate system.

4. A method of manufacturing semiconductor devices in which information on chips is stored as a map on the basis of results of a test of the chips on a wafer before the wafer is cut into chip pieces, and the test results are analyzed to enable a subsequent manufacturing process to be performed in a rational manner, said method comprising:
(1) a first step of preparing data such that all chips having the same coordinates on wafers in one lot having the same coordinates can be superposed on the basis of data obtained at the time of said test;
(2) a second step of detecting an origin on the wafer on the basis of the data obtained in the first step by counting the number of chips in each of longitudinal and lateral rows at predetermined positions and determining an X-axis and a Y-axis respectively bisecting the longitudinal and lateral rows at the centers thereof;
(3) a third step of determining coordinates for the chips in one of predetermined quadrants on the basis of the origin detected in the second step; and
(4) a fourth step of correcting a deficient chip in the other three quadrants on the basis of the coordinates of the chips in the predetermined quadrant determined in the third step.

5. A method of manufacturing semiconductor devices according to claim 4, wherein the wafer is positioned at the time of exposure on the basis of an X-axis corresponding to an orientation flat and a Y-axis corresponding to a straight line perpendicular to the orientation flat and tangential to the circumference of the wafer, and the predetermined quadrant for first determining the coordinates is in the vicinity of the point of intersection of the X-axis and the Y-axis.

6. A method of manufacturing semiconductor devices according to claim 4 or 5, wherein coordinates of chip layout data at the time of exposure and chip layout data according to claim 1 are made to coincide with each other.
